# EUROPÄISCHE PATENTSCHRIFT

(11) **EP 0 756 325 B1**
(45) Veröffentlichungstag und Bekanntmachung des Hinweises auf die Patenterteilung: **27.11.2002**
(21) Anmeldenummer: 96202089.7
(22) Anmeldetag: 24.07.1996
(51) Int. Cl.: H01L 23/492, H01L 21/60

(54) **Halbleitervorrichtung mit einem Träger**
Semiconductor device having a base
Dispositif semi-conducteur comprenant une base

(30) Priorität: 27.07.1995 DE 19527209
(43) Veröffentlichungstag der Anmeldung: 29.01.1997
(73) Patentinhaber: Philips Corporate Intellectual Property GmbH, 20099 Hamburg (DE); Koninklijke Philips Electronics N.V., 5621 BA Eindhoven (NL)
(72) Erfinder: Bareither, Wolfgang, Dipl.-Ing., Röntgenstrasse 24, 22335 Hamburg (DE); Schröder, Harald, Dr. Dipl.-Phys., Röntgenstrasse 24, 22335 Hamburg (DE); Tommalla, Dieter, Physik Ing., Röntgenstrasse 24, 22335 Hamburg (DE)
(74) Vertreter: Schmalz, Günther, Dipl.-Ing.

(56) Entgegenhaltungen:
- DE-A- 2 930 779
- DE-U- 9 212 486
- US-A- 4 772 935
- US-A- 4 954 870
- PATENT ABSTRACTS OF JAPAN vol. 010, no. 306 (E-446), 17. Oktober 1986 & JP 61 119049 A (NEC CORP), 6. Juni 1986
- H. FÜHRLING: "Multiepitaxial-Planar-Leistungstransistor en" ELEKTRONIK., Bd. 30, Nr. 5, März 1981, Seite 26 XP002082872 MUNCHEN DE

## Beschreibung

Die Erfindung betrifft eine Halbleitervorrichtung, die einen Träger, mindestens ein auf diesem angebrachtes Halbleiterbauelement und eine mehrschichtige Metallisierung zwischen dem Halbleiterbauelement und dem Träger umfaßt.

Zur Herstellung von Halbleitervorrichtungen werden zunächst diskrete Halbleiterbauelemente z.B. Transistoren und Systeme von Transistoren mit anderen Bauelementen, z.B. digitale Transistoren, Dioden, Sensoren, Widerstände oder kleine Kapazitäten hergestellt. Dazu erzeugt man auf einer Siliziumscheibe (Wafer) gleichzeitig mehrere tausend solcher diskreten Bauelemente.

Die Siliziumscheibe wird dann in einzelne Transistorsysteme (Chips) zerschnitten. Jedes dieser Systeme wird auf einem Träger befestigt,mit elektrischen Zuleitungen versehen und in ein Gehäuse eingebaut. Die eingehausten Transistoren, Dioden usw. werden dann mit dem Gehäuse in Schaltungen oder Baugruppen eingelötet.

Für die Funktionstüchtigkeit eines diskreten Halbleiterbauelementes oder eines ICs ist es wichtig, daß ein guter elektrischer und thermischer Kontakt zwischen dem Bauelementkörper, den Elektroden, dem Träger, dem Gehäuse und den Zuleitungen besteht. Insbesondere stellt es ein Problem dar, nicht-gleichrichtende Metall-Halbleiter-Kontakte herzustellen, um bei den Dioden, Transistoren, usw. die Halbleiterzonen mit den Elektroden und den externen elektrischen Zuleitungen zu verbinden.

Die Metall- Halbleiter-Kontakte können entweder ohmische Kontakte oder Gleichrichterkontakte sein. Welche der beiden Verbindungen zustandekommt, hängt von der Art des verwendeten Kontaktmaterials, der Herstellungstechnik und weiteren Faktoren ab. Bei einer ohmschen Verbindung ist die Stärke des gesamten Stromflusses von der Polarität der angelegten Spannung unabhängig. Der Stromfluß durch einen Gleichrichterkontakt hängt dagegen von der Richtung des angelegten Feldes ab.

Außerdem muß eine gute mechanische Verbindung zwischen Gehäuse und dem Bauelement bestehen.

Es sind verschiedene Verfahren bekannt, um ein Halbleiterelement aus Silicium mittels einer mehrschichtigen Metallisierung, die gleichzeitig eine Elektrode bildet, auf einen Träger oder einem Chipbefestigungsteil zu befestigen.

Aus der DE 29 30 779 ist bereits eine Halbleitervorrichtung bekannt, die einen Träger, ein auf diesen Träger angebrachtes Halbleiterbauelement und zwischen dem Halbleiterbauelement und dem Träger eine Gold und Germanium enthaltende Metallschicht umfaßt, wobei auf einer Oberfläche des Halbleiterbauelementes eine erste Metallschicht aus einem Metall der Gruppe Vanadium, Aluminium, Titan, Chrom, Molybdän und einer Nickel-Chrom-Legierung aufgebracht ist, auf die erste Metallschicht eine zweite Metallschicht aus einem Metall der Gruppe Kupfer , Legierung auf Kupferbasis, Nickel und Legierung auf Nickelbasis aufgebracht ist und auf die zweite Metallschicht die Gold und Germanium enthaltende Metallschicht aus einer Gold-Germanium-Legierung oder einer Legierung auf der Basis von Gold - Germanium aufgebracht ist.

Bei diesen Verbindungsschichten können jedoch Diffusionsvorgänge in der Metallisierungsschicht zu Komplikationen führen, die sich durch eine zu kurze Lebensdauer, insbesondere bei höheren Betriebstemperaturen, äußern. Außerdem ist der Kontakt zwischen dem Halbleiter und der Metallisierung unzureichend.

Aufgabe dieser Erfindung ist es, eine Halbleitervorichtung zur Verfügung zu stellen, die einen Träger, mindestens ein auf diesem angebrachtes Halbleiterbauelement und eine mehrschichtige Metallisierung zwischen dem Halbleiterbauelement und dem Träger umfaßt und einen dauerhaften elektrischen, mechanischen und thermischen Kontakt zwischen dem Halbleiterbauelement, der Metallisierung und dem Träger mit verbesserter Langzeitstabilität bildet.

Erfindungsgemäß wird die Aufgabe gelöst durch eine Halbleitervorrichtung, die einen Träger, mindestens ein auf diesem angebrachtes Halbleiterbauelement und eine mehrschichtige Metallisierung zwischen dem Halbleiterbauelement und dem Träger umfaßt, wobei auf der Oberfläche des Halbleiterbauelementes eine erste Metallschicht aus Gold oder einer Goldlegierung, aufgebracht ist, auf die erste Metallschicht eine zweite Metallschicht aus Titan aufgebracht ist, auf die zweite Metallschicht eine dritte Metallschicht aus Nickel aufgebracht ist und auf die dritte Metallschicht eine vierte Metallschicht aus einer binären oder ternären Gold-Germanium-Legierung aufgebracht ist.

Eine derartige Halbleitervorrichtung zeichnet sich durch überragende Langlebigkeit aus. Auch bei höheren Temperaturen tritt keine oder nur eine geringe Alterung in der Kontaktzone ein, sodaß eine derartige Halbleitervorrichtung für einen Einsatz bis 150°C Umgebungstemperatur, wie sie z.B. bei Anwendungen im Automobilbereich auftreten, geeignet ist.

Im Rahmen der vorliegenden Erfindung ist es bevorzugt, daß das Halbleiterbauelement ein PNP-Transistor ist und die erste Metallschicht aus Gold besteht. Diese Halbleiteranordnung hat eine niederohmige Kontaktschicht und eine stark erhöhte Lebensdauer.

Im Rahmen der vorliegenden Erfindung ist es besonders bevorzugt, daß das Halbleiterbauelement ein NPN -Transistor oder eine PN-Diode ist und die erste Metallschicht aus einer Goldarsenlegierung besteht.

Durch diese Anordnung entsteht an dem Übergang von der Metallisierung zu dem Halbleiterbauelement unter thermischer Einwirkung die gleiche Ladungsträgerart, die auch im Halbleiter an dieser Stelle herrscht. Dadurch ist der Übergang niederohmig und grenzschichtfrei, d.h. ohne Gleichrichterwirkung.

Es kann auch bevorzugt sein, daß in der Halbleitervorrichtung die erste Metallschicht eine Schichtdicke von 0,1 bis 0,5 µm, die zweite Metallschicht eine Schichtdicke von 0,05 bis 0,3 µm, die dritte Metallschicht eine Schichtdicke von 0,05 bis 0,5 µm und die vierte Metallschicht eine Schichtdicke von 0,5 bis 5 µm aufweist.

Nachstehend wird die Erfindung anhand von einer Figur weiter erläutert und es werden Beispiele angegeben.

Es zeigt:

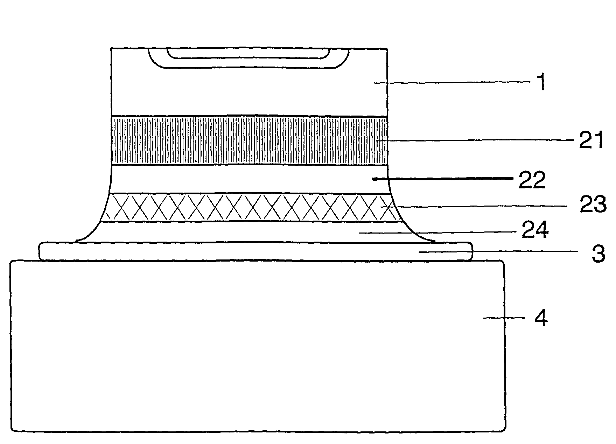

- **Fig. 1**: eine Querschnittsansicht einer Halbleitervorrichtung gemäß dieser Erfindung.

Die erfindungsgemäße Halbleitervorrichtung umfaßt ein Halbleiterbauelement 1, das ein diskreter bipolarer Transistor, insbesondere Planartransistor oder Feldeffekttransistor, aber auch eine Halbleiterdiode, insbesondere eine Flächendioden oder Schottky-Diode, weiterhin ein Sensorbauelement oder eine Kombination eines Transistors mit anderen Bauelementen, z.b. ein digitaler Transistor sein kann. Diese oder andere Halbleiterbauelemente werden mittels einer mehrschichtigen Metallisierung **21, 22, 23 und 24,** die gleichzeitig die Kollektorelektrode bildet, auf einen Träger oder ein Chipbefestigungsteil **4**, der eine weitere Metallschicht **3** trägt, aufgelötet und anschließend in einem Gehäuse gefaßt. Nachdem sie mit elektrischen Anschlüssen versehen worden ist, kann sie zum Bestücken von Leiterplatten usw. eingesetzt werden.

Die Halbleiterbauelemente **1** werden überwiegend aus Silizium gefertigt. Für diskrete Bauelemente handelt es sich meistens um ein dünnes dotiertes Siliziumplättchen mit einer Schichtdicke von 0,05 bis 0,6 mm und einem Querschnitt von 0,02 bis 20 mm².

Die erste Schicht der Metallisierung **21** besteht aus Gold oder einer Goldlegierung, je nachdem ob die angrenzende Schicht des Bauelementes, z.B. die Kollektorschicht eines Transistors, p- oder n-leitend ist. Für n-dotierte Kollektoerschichten ist die Verwendung einer Goldarsenlegierung mit einem Arsengehalt der Goldarsenlegierung zwischen 0,05 und 1,0 Gew.-% bevorzugt.

Die zweite Schicht der Metallisierung **22** besteht aus Titan, die dritte **23** aus Nickel, die vierte **24** aus einer binären oder ternären Gold-Germanium-Legierung. Die binären Gold-Germanium-Legierungen haben bevorzugt einen Germaniumgehalt von 4 bis 20 Gew.-%. Als ternäre Gold-Germanium-Legierungen können solche mit Bor oder Antimon als drittem Legierungspartner eingesetzt werden.

Diese Schichten können durch Aufdampfen im Hochvakuum, z.B. durch Elektronenstrahlverdampfung oder durch Kathodenzerstäubung u.ä. hergestellt werden. Nach dem Aufbringen der ersten, goldhaltigen Schicht wird der Wafer einer thermischen Behandlung unter reduzierenden Bedingungen unterzogen. Dabei bildet Gold mit Silizium ein niedrigschmelzendes Eutektikum und man erhält einen niederohmigen Kontakt.

Wenn man Goldlegierungen mit Metallen der dritten Grupe des periodischen Systems (B,Al, Ga oder In) oder mit Metallen der fünften Gruppe (P, As, Sb) verwendet, erreicht man eine Dotierung der Grenzschicht zu dem reinen Halbleitermetall Silizium oder Germanium. Während der thermischen Behandlung verbindet sich der Goldanteil der Legierung mit dem Si oder Ge zum jeweiligen Eutektikum. Die Legierungsbeimetalle lösen sich in einer Schicht des Halbleitergitters von einer vorberechneten Dicke und dotieren diese. Eine solche zusätzliche Dotierung verbessert den Kontakt bei Halbleitern mit niedrigdotierter Kollektorzone.

Die Montage auf dem Träger erfolgt im allgemeinen durch Löten, insbesondere durch Hartlöten. Dazu muß auch der Träger mit einer lötfähigen Metallschicht versehen sein. Diese Lötbeschichtung kann aus Silber, Gold, einer Sn/Pb - Legierung u.ä. bestehen.

In dem erfindungsgemäßen Aufbau liegt ein Metallsystem vor, daß zwar inhomogen ist, sich jedoch in einem quasithermodynamischen Gleichgewicht befindet. Dadurch werden Oxidation durch Sauerstoffdiffusion und eine Interdiffusion der Metalle untereinander und mit den Halbleitern unterdrückt. Das Langzeitverhalten untere Temperaturbelastung ist dadurch hervorragend verbessert. Beschleunigte Lebensdauertests (ALT) ergaben eine Erhöhung der Lebensdauer gegenüber Halbleitervorrichtungen nach dem Stand der Technik um das sechs- bis siebenfache.

### Beispiel 1

### NPN-Transistor

Zur Herstellung von NPN-Transistoren wurden auf der Vorderseite einer n-dotierten Siliziumsubstratscheibe in bekannter Art und Weise die p- und n- leitenden Bereiche erzeugt. Dann wurde die Rückseite der Siliziumsubstratscheibe mit einer ersten Schicht aus einer AuAs-Legierung mit einem Arsengehalt von 0,4 Gew.-% bedampft. Die AuAs-Schicht hat eine Schichtdicke von 0,3µm.
Die so metallisierte Substratscheibe wurde anschließend einer Wärmebehandlung von 30 min bei 420°C unterzogen. Nach der Abkühlung auf Raumtemperatur wurde die Oberfläche der AuAs-Metallisierungsschicht durch Sputterätzen mit Argon-Ionen gereinigt, um Oxide oder andere Verunreinigungen zu entfernen. Anschließend wurde auf die erste Metallisierungsschicht eine zweite Schicht aus Titan mit einer Dicke von 0,15 µm abgeschieden. Danach erfolgte die Abscheidung einer dritten Schicht aus Nickel mit einer Dicke von 0,25 µm und schließlich die Abscheidung einer vierten Schicht aus AuGe mit einem Germaniumgehalt von 12 Gew.-% und einer Dicke von 1,3 µm.

Die so metallisierte Siliziumsubstratscheibe wurde mittels einer Diamantsäge in einzelne Chips getrennt. Die Chips wurden auf einen silberplattierten Träger aufgelötet. Auf diese Art und Weise wurden Halbleiterbauelemente hergestellt, die jeweils einen diskreten NPN-Transistor-Chip enthielten.

Diese NPN-Transistoren haben hervorragende elektrische Eigenschaften. Bei Lebensdaueruntersuchungen zeigten diese Transistoren eine deutlich verbesserte Langzeitstabilität und eine verringerte Ausfallrate. Bei einer Hochtemperaturauslagerung bei 150°C war der Kontaktwiderstand nach 3000 h noch unverändert.

### Beispiel 2

### PNP-Transistor

Zur Herstellung von PNP-Transistoren wurden auf der Vorderseite einer p-dotierten Siliziumsubstratscheibe in bekannter Art und Weise die p- und n- leitenden Bereiche erzeugt. Dann wurde die Rückseite der Siliziumsubstratscheibe mit einer ersten Schicht aus Gold bedampft. Die Au-Schicht hatte eine Schichtdicke von 0,3µm. Die so metallisierte Substratscheibe wurde anschließend einer Wärmebehandlung von 20 min bei 430°C unterzogen. Nach der Abkühlung auf Raumtemperatur wurde die Oberfläche der Au-Metallisierungsschicht durch Sputterätzen mit Argon-Ionen gereinigt, um Oxide oder andere Verunreinigungen zu entfernen. Anschließend wurde auf die erste Metallisierungsschicht eine zweite Schicht aus Titan mit einer Dicke von 0,15 µm abgeschieden. Danach erfolgte die Abscheidung einer dritten Schicht aus Nickel mit einer Dicke von 0,25 µm und schließlich die Abscheidung einer vierten Schicht aus AuGe mit einem Germaniumgehalt von 12 Gew.-% und einer Dicke von 1,3 µm.

Die so metallisierte Siliziumsubstratscheibe wurde mittels einer Diamantsäge in einzelne Chips getrennt. Die Chips wurden auf einen silberplattierten Träger aufgelötet. Auf diese Art und Weise wurden Halbleiterbauelemente hergestellt, die jeweils einen diskreten PNP-Transistor-Chip enthielten.

Diese PNP-Transistoren haben hervorragende elektrische Eigenschaften. Bei Lebensdaueruntersuchungen zeigten diese Transistoren eine deutlich verbesserte Langzeitstabilität und eine verringerte Ausfallrate. Bei einer Hochtemperaturauslagerung bei 150°C war der Kontaktwiderstand nach 3000 h noch unverändert.

### Beispiel 3

### PN-Diode

Zur Herstellung von PN-Dioden wurden auf der Vorderseite einer n-dotierten Siliziumsubstratscheibe in bekannter Art und Weise die p- und n- leitenden Bereiche erzeugt. Dann wurde die Rückseite der Siliziumsubstratscheibe mit einer ersten Schicht aus einer AuAs-Legierung mit einem Arsengehalt von 0,4 Gew.-% bedampft. Die AuAs-Schicht hat eine Schichtdicke von 0,3µm. Die so metallisierte Substratscheibe wurde anschließend einer Wärmebehandlung von 30 min bei 420°C unterzogen. Nach der Abkühlung auf Raumtemperatur wurde die Oberfläche der AuAs-Metallisierungsschicht durch Sputterätzen mit Argon-Ionen gereinigt, um Oxide oder andere Verunreinigungen zu entfernen. Anschließend wurde auf die erste Metallisierungsschicht eine zweite Schicht aus Titan mit einer Dicke von 0,15 µm abgeschieden. Danach erfolgte die Abscheidung einer dritten Schicht aus Nickel mit einer Dicke von 0,25 µm und schließlich die Abscheidung einer vierten Schicht Schicht aus AuGe mit einem Germaniumgehalt von 12 Gew.-% und einer Dicke von 1,3 µm.

Die so metallisierte Siliziumsubstratscheibe wurde mittels einer Diamantsäge in einzelne Chips getrennt. Die Chips wurden auf einen silberplattierten Träger aufgelötet. Auf diese Art und Weise wurden Halbleiterbauelemente hergestellt, die jeweils einen diskreten PN-Dioden-Chip enthielten.

Diese PN-Dioden haben hervorragende elektrische Eigenschaften. Bei Lebensdaueruntersuchungen zeigten diese Dioden eine deutlich verbesserte Langzeitstabilität und eine verringerte Ausfallrate. Bei einer Hochtemperaturauslagerung bei 150°C war der Kontaktwiderstand nach 3000 h noch unverändert.

## Patentansprüche

1. Halbleitervorrichtung, die einen Träger, mindestens ein auf diesem angebrachtes Halbleiterbauelement und eine mehrschichtige Metallisierung zwischen dem Halbleiterbauelement und dem Träger umfaßt, wobei auf der Oberfläche des Halbleiterbauelementes eine erste Metallschicht aus Gold oder einer Goldlegierung, aufgebracht ist, auf die erste Metallschicht eine zweite Metallschicht aus Titan aufgebracht ist, auf die zweite Metallschicht eine dritte Metallschicht aus Nickel aufgebracht ist und auf die dritte Metallschicht eine vierte Metallschicht aus einer binären oder ternären Gold-Germanium-Legierung aufgebracht ist.

2. Halbleitervorrichtung nach Anspruch 1,
wobei
das Halbleiterbauelement ein PNP-Transistor ist und die erste Metallschicht aus Gold besteht.

3. Halbleitervorrichtung nach Anspruch 1,
wobei
das Halbleiterbauelement ein NPN -Transistor oder eine PN-Diode ist und die erste Metallschicht aus einer Goldarsenlegierung besteht.

4. Halbleitervorrichtung nach Anspruch 1 bis 3,
wobei
die erste Metallschicht eine Schichtdicke von 0,1 bis 0,5 µm, die zweite Metallschicht eine Schichtdicke von 0,05 bis 0,5 µm, die dritte Metallschicht eine Schichtdicke von 0,05 bis 0,5 µm und die vierte Metallschicht eine Schichtdicke von 0,5 bis 5 µm aufweist.

5. Verfahren zur Herstellung einer Halbleitervorrichtung gemäß Anspruch 1 indem auf der Oberfläche des Halbleiterbauelements mehrere Metallschichten durch Aufdampfen in Hochvakuum oder durch Kathodenzerstäubung hergestellt werden,
wobei
eine erste Metallschicht aus Gold abgeschieden wird,
die Halbleitervorrichtung danach einer 20-minütigen Wärmebehandlung bei 430 °C unterzogen wird,
eine zweite Schicht aus Titan
eine dritte Schicht aus Nickel und
eine vierte Schicht aus einer binären oder ternären Gold-Germanium-Legierung abgeschieden werden.

6. Verfahren zur Herstellung einer Halbleitervorrichtung gemäß Anspruch 1 indem auf der Oberfläche des Halbleiterbauelements mehrere Metallschichten durch Aufdampfer in Hochvakuum oder durch Kathodenzerstäubung hergestellt werden,
wobei
eine erste Metallschicht aus einer Goldlegierung abgeschieden wird,
die Halbleitervorrichtung danach einer 30-minütigen Wärmebehandlung bei 420 °C unterzogen wird,
eine zweite Schicht aus Titan
eine dritte Schicht aus Nickel und
eine vierte Schicht aus einer binären oder ternären Gold-Germanium-Legierung abgeschieden werden.

## Claims

1. A semiconductor device which comprises a carrier, at least one semiconductor component provided thereon, and a multilayer metallization between the semiconductor component and the carrier, wherein a first metal layer of gold or a gold alloy is provided on the surface of the semiconductor component, a second metal layer of titanium is provided on the first metal layer, a third metal layer of nickel is provided on the second metal layer, and a fourth metal layer made of a binary or ternary gold-germanium alloy is provided on the third metal layer.

2. A semiconductor device as claimed in Claim 1, wherein the semiconductor component is a PNP transistor and the first metal layer is made of gold.

3. A semiconductor device as claimed in Claim 1, wherein the semiconductor component is an NPN transistor or a PN diode, and the first metal layer consists of a gold-arsenic alloy.

4. A semiconductor device as claimed in Claims 1 to 3, wherein the first metal layer has a layer thickness of 0.1 to 0.5 µm, the second metal layer a layer thickness from 0.05 to 0.3 µm, the third metal layer a layer thickness from 0.05 to 0.5 µm, and the fourth metal layer a layer thickness from 0.5 to 5 µm.

5. A method of manufacturing a semiconductor device as claimed in claim 1 whereby several metal layers are provided on the surface of a semiconductor component by vapor deposition in high vacuum or cathode sputtering, wherein:
a first metal layer of gold is deposited,
the semiconductor device is subsequently given a heat treatment of 20 minutes at 430 °C,
a second layer of titanium is provided,
a third layer of nickel is deposited, and
a fourth layer of a binary or tertiary alloy of gold and germanium is deposited.

6. A method of manufacturing a semiconductor device as claimed in claim 1 whereby several metal layers are provided on the surface of a semiconductor component by vapor deposition in high vacuum or cathode sputtering, wherein:
a first metal layer of a gold alloy is deposited,
the semiconductor device is subsequently given a heat treatment of 30 minutes at 420 ° C, a second layer of titanium is provided,
a third layer of nickel is deposited, and
a fourth layer of a binary or tertiary alloy of gold and germanium is deposited.

## Revendications

1. Dispositif semi-conducteur qui comprend un support, au moins un composant semi-conducteur disposé sur celui-ci et une métallisation à plusieurs couches entre le composant semi-conducteur et le support, dans lequel une première couche métallique en or ou en un alliage d'or est appliqué à la surface du composant semi-conducteur, une deuxième couche métallique en titane est appliquée sur la première couche métalliques, une troisième couche métallique en nickel est appliquée sur la deuxième couche métallique et une quatrième couche métalliques en un alliage or/germanium binaire ou ternaire est appliquée sur la troisième couche métallique.

2. Dispositif semi-conducteur selon la revendication 1, dans lequel le composant semi-conducteur est un transistor PNP et la première couche métallique est composée d'or.

3. Dispositif semi-conducteur selon la revendication 1, dans lequel le composant semi-conducteur est un transistor NPN ou une diode PN et la première couche métallique est composée d'un alliage d'or-arsenic.

4. Dispositif semi-conducteur selon l'une des revendications 1 à 3, dans lequel la première couche métallique présente une épaisseur de couche de 0,1 à 0,5 µm, la deuxième couche métallique une épaisseur de couche de 0,05 à 0,3 µm, la troisième couche métallique une épaisseur de couche de 0,05 à 0,5 µm et la quatrième couche métallique une épaisseur de couche de 0,5 à 5 µm.

5. Procédé de fabrication d'un dispositif semi-conducteur selon la revendication 1, en appliquant plusieurs couches métalliques par pulvérisation sous vide ou par pulvérisation cathodique à la surface du composant semi-conducteur, dans lequel
une première couche métallique en or est déposée,
le dispositif semi-conducteur est soumis à un traitement thermique à 430°C pendant une vingtaine de minutes;
une deuxième couche en titane est déposée,
une troisième couche en nickel est déposée et
une quatrième couche en un alliage d'or-germanium binaire ou ternaire est déposée.

6. Procédé de fabrication d'un dispositif semi-conducteur selon la revendication 1, en appliquant plusieurs couches métalliques par pulvérisation sous vide ou par pulvérisation cathodique à la surface du composant semi-conducteur, dans lequel
une première couche métallique en un alliage d'or est déposée,
le dispositif semi-conducteur est soumis à un traitement thermique à 430°C pendant une trentaine de minutes;
une deuxième couche en titane est déposée,
une troisième couche en nickel est déposée et
une quatrième couche en un alliage d'or-germanium binaire ou ternaire est déposée.
